# EUROPEAN PATENT APPLICATION

(11) **EP 2 204 855 A1**
(43) Date of publication of application: **07.07.2010**
(21) Application number: 08841558.3
(22) Date of filing: 17.09.2008
(51) Int. Cl.: H01L 33/00

(54) **SEMICONDUCTOR LIGHT EMITTING ELEMENT, SEMICONDUCTOR LIGHT EMITTING DEVICE USING THE ELEMENT, AND METHOD FOR MANUFACTURING THE DEVICE**

(30) Priority: 23.10.2007 JP 2007274998
(71) Applicant: Panasonic Corporation, Kadoma-shi Osaka 571-8501 (JP)
(72) Inventor: KAMEI, Hidenori, Osaka-shi Osaka 540-6207 (JP)
(74) Representative: Grünecker, Kinkeldey, Stockmair & Schwanhäusser Anwaltssozietät
(86) International application number: PCT/JP2008/002557
(87) International publication number: WO 2009/054088

(57) **Abstract**

The present invention provides a semiconductor light emitting element capable of improving light extraction efficiency and a semiconductor light emitting device using the semiconductor light emitting element without adding any manufacturing step

A semiconductor light emitting element 1 includes a compound semiconductor layer 3 stacked on a single crystal substrate, and is formed by separating the single crystal substrate into individual rectangular pieces. An individual piece 2, which is the separated single crystal substrate, is oriented at a predetermined angle with respect to a cleavage plane of a crystal structure of the single crystal substrate so that long side surfaces 21 and 23 are different from the cleavage planes.

## Description

### TECHNICAL FIELD

The present invention relates to semiconductor light emitting elements, in which compound semiconductor layers are stacked on single crystal substrates, and semiconductor light emitting devices using the elements.

### BACKGROUND ART

Technology for improving light extraction efficiency and luminance of a semiconductor light emitting element is described in Patent Document 1. In a gallium nitride compound semiconductor element in Patent Document 1, asperities are formed by etching, on a side surface of a substrate or a side surface of a gallium nitride compound semiconductor element stacked on the substrate.

As such, when an emitting surface for emitting light has the asperities, the degree of total reflection of light coming from the inside on the surface can be reduced more than in a smooth surface. Thus, an improvement in the light extraction efficiency can be expected.

### CITATION LIST

### PATENT DOCUMENT

PATENT DOCUMENT 1: Japanese Patent Publication No. 2004-6662

### SUMMARY OF THE INVENTION

### TECHNICAL PROBLEM

However, in the gallium nitride compound semiconductor element described in Patent Document 1, asperities are formed by etching, on the side surface of the substrate or the side surface of the gallium nitride compound semiconductor stacked on the substrate. Thus, in the manufacturing process, an etching step needs to be added after stacking the gallium nitride compound semiconductor on the substrate. This complicates the manufacturing process and increases the manufacturing cost. In this method, since the asperities are reduced with an increase in an etching depth, it is difficult to form the asperities over the entire surface.

An objective of the present invention is to form asperities over the entire surface of a side surface of a semiconductor light emitting element without adding any manufacturing step so as to provide a semiconductor light emitting element capable of improving light extraction efficiency, a semiconductor light emitting device using the element, and a method of manufacturing the device.

### SOLUTION TO THE PROBLEM

The semiconductor light emitting element of the present invention includes a compound semiconductor layer stacked on a single crystal substrate, and is formed by separating the single crystal substrate into individual pieces. A side surface of the separated single crystal substrate is different from a cleavage plane of the single crystal substrate.

In particular, in the semiconductor light emitting element of the present invention, each of the individual pieces separated from the single crystal substrate, on which the compound semiconductor is stacked, has a rectangular shape. Neither of side surfaces on the longer sides of the rectangle is a cleavage plane.

### ADVANTAGES OF THE INVENTION

The present invention only requires that the side surface of the single crystal substrate be different from the cleavage plane, when separating the single crystal substrate in a manufacturing process. There is thus no need to add an extra manufacturing step to improve the light extraction efficiency. Therefore, the present invention can provide a semiconductor element with high luminance efficiency without increasing manufacturing costs.

Since each individual piece separated from the single crystal substrate has a rectangular shape, and neither of the side surfaces on the longer sides is the cleavage plane; the light extraction efficiency of the entire semiconductor light emitting element can be improved as compared to the case where all the side surfaces are the cleavage planes; even if the side surfaces on the shorter sides are the cleavage planes totally reflecting light.

### BRIEF DESCRIPTION OF THE DRAWINGS

[FIG. 1] FIG. 1 is a cross-sectional view of a semiconductor light emitting element according to an embodiment of the present invention.
[FIG. 2] FIG. 2 is a plan view of the semiconductor light emitting element according to the embodiment of the present invention.
[FIG. 3] FIG. 3 illustrates a wafer, and a compound semiconductor layer and an electrode, which are formed on the wafer, according to the embodiment of the present invention, when the main surface is the c plane.
[FIG. 4] FIG. 4 is a perspective view illustrating the relationship between the wafer and cleavage planes according to the embodiment of the present invention, when the main surface is the c plane.
[FIG. 5] FIG. 5 illustrates the wafer, and the compound semiconductor layer and the electrode, which are formed on the wafer, according to the embodiment of the present invention, when the main surface is the a plane.
[FIG. 6] FIG. 6 is a perspective view illustrating the relationship between the wafer and the cleavage planes according to the embodiment of the present invention, when the main surface is the a plane.
[FIG.7] FIG. 7 illustrates the wafer, and the compound semiconductor layer and the electrode, which are formed on the wafer, according to the embodiment of the present invention, when the main surface is the m plane.
[FIG. 8] FIG. 8 is a perspective view illustrating the relationship between the wafer and the cleavage planes according to the embodiment of the present invention, when the main surface is the m plane.
[FIG. 9] FIG. 9 illustrates a semiconductor light emitting device mounting the semiconductor light emitting element of the present invention on a submount.
[FIG. 10] FIG. 10 illustrates a semiconductor light emitting device according to another embodiment, mounting on a submount, the semiconductor light emitting element of the present invention.
[FIG. 11] FIG. 11 illustrates a semiconductor light emitting device according to another embodiment mounting on a submount, the semiconductor light emitting element of the present invention.
[FIG. 12] FIG. 12 illustrates a semiconductor light emitting device according to another embodiment mounting on a submount, the semiconductor light emitting element of the present invention.
[FIG. 13] FIG. 13 illustrates a semiconductor light emitting device according to another embodiment mounting on a submount, the semiconductor light emitting element of the present invention.
[FIG. 14] FIG. 14 illustrates a semiconductor light emitting device mounting the semiconductor light emitting element of the present invention on a submount, and having fine asperities on a light emitting plane.

### DESCRIPTION OF REFERENCE CHARACTERS

- 1: Semiconductor Light Emitting Element
- 2: Individual Piece of Substrate
- 3: Compound Semiconductor Layer
- 4: N-Type Electrode
- 5: P-Type Electrode
- 10: Wafer
- 11, 12: OF Planes
- 20: Mounting Surface
- 21-24: Side Surfaces
- 31: N-Type Semiconductor Layer
- 32: Active Layer
- 33: P-Type Semiconductor Layer

### DESCRIPTION OF EMBODIMENTS

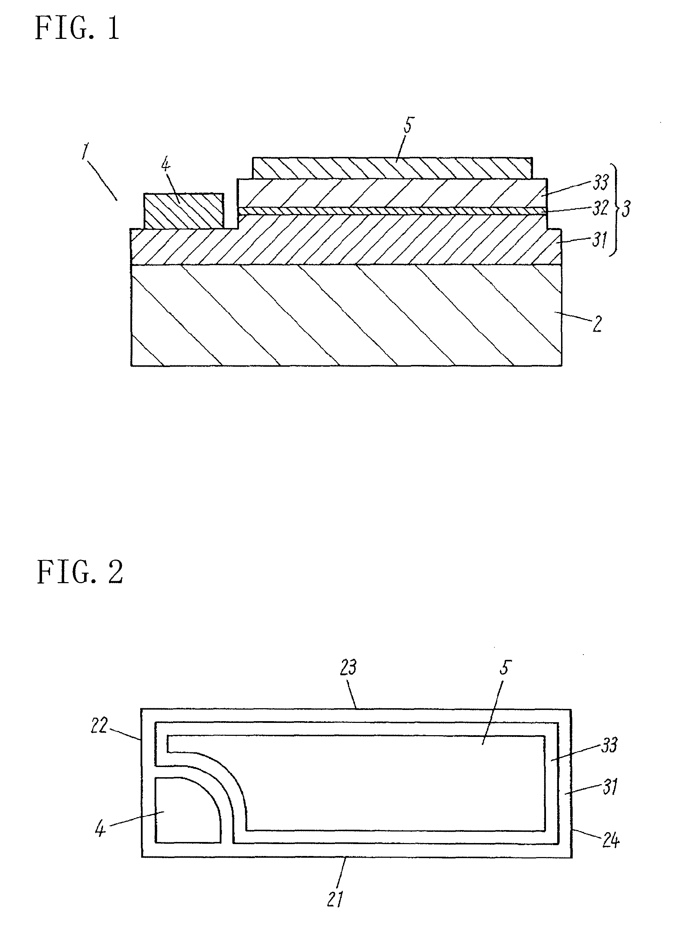

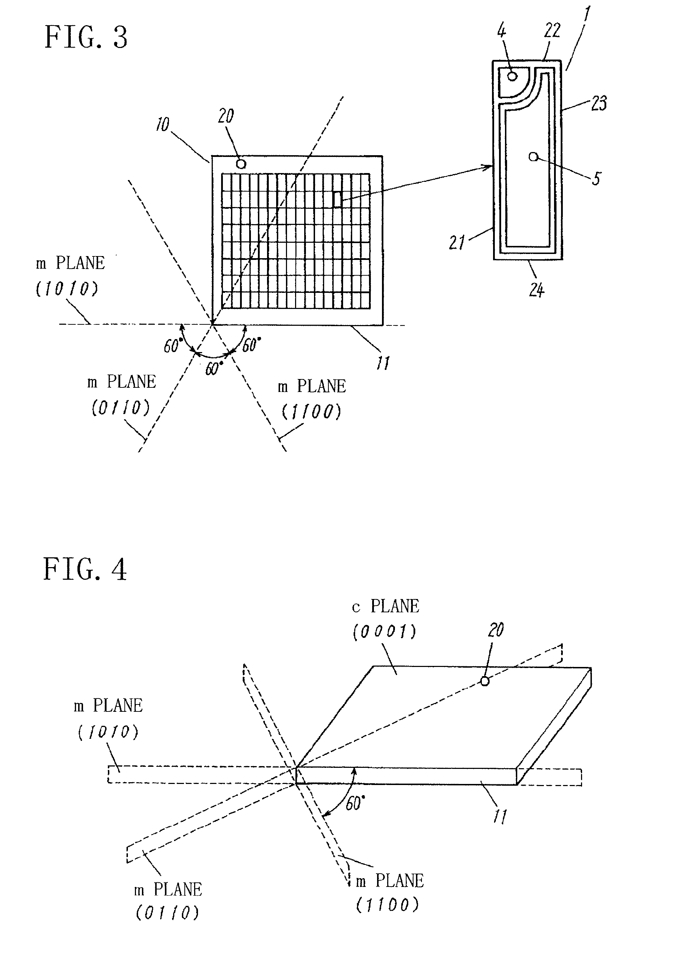

A semiconductor light emitting element according to an embodiment of the present invention will be described hereinafter with reference to FIG. 1, FIG. 2, and FIG. 3. FIG. 1 is a cross-sectional view of the semiconductor light emitting element according to the embodiment. FIG. 2 is a plan view. FIG. 3 illustrates the positional relationship among a crystal plane, a wafer, and the semiconductor light emitting element, when the semiconductor light emitting element is cut out from the wafer.

As shown in FIG. 1, a semiconductor light emitting element 1 includes an individual piece 2 of a substrate, a compound semiconductor layer 3, an n-type electrode 4, and a p-type electrode 5; and is formed by separating a single crystal substrate in a wafer state. While the individual piece 2 may be made of any material having optical transparency, in this embodiment, it can be made of any one of gallium nitride compound semiconductor, silicon carbide semiconductor, zinc oxide compound semiconductor, and aluminum nitride compound semiconductor, which have hexagonal crystal structures. Throughout the specification and claims, gallium nitride compound semiconductor, and aluminum nitride compound semiconductor are generally referred to as "nitride compound semiconductor."

Referring to FIG. 3, the semiconductor light emitting element 1 is formed by separating a mounting surface 20 of the wafer into substantially rectangular pieces. Each of a side surface 21 and a side surface 23 of the individual piece 2 is different from a cleavage plane, when separating the wafer into the individual pieces. More fine asperities are formed on the side surfaces than in the case where the wafer is separated along the cleavage plane. These asperities are easily formed on the side surfaces as the asperities linearly extending in a vertical direction on the main surface of the individual piece. The method of cutting out the individual piece along the cleavage plane will be described later with reference to FIG. 3.

Referring to FIG. 1 again, the compound semiconductor layer 3 is stacked on the crystal plane with specific orientation of the individual piece 2 having a hexagonal crystal structure. The surface, on which the compound semiconductor layer 3 is stacked, is referred to as a "main surface." In order to improve crystal quality of the compound semiconductor layer 3, the main surface, on which the compound semiconductor layer 3 is stacked, may be oriented at an angle ranging 0.1°-5° with respect to the crystal plane of the individual piece 2.

The compound semiconductor layer 3 may be a gallium nitride compound semiconductor layer, when the individual piece 2 is made of, e.g., nitride compound semiconductor (e.g., GaN, AIN, InN, AlGaN, InGaN, InAlN, or InAlGaN), silicon carbide semiconductor (SiC), or zinc oxide compound semiconductor (e.g., ZnO, or ZnMgO); and it may be a zinc oxide compound semiconductor layer, when the substrate is made of zinc oxide compound semiconductor. In particular, when the individual piece 2 is made of nitride compound semiconductor, the compound semiconductor layer 3 is preferably made of gallium nitride compound semiconductor. When the individual piece 2 is made of zinc oxide compound semiconductor, the compound semiconductor layer 3 is preferably a zinc oxide compound semiconductor layer.

When the compound semiconductor layer 3 made of such a material is grown on a single crystal substrate 2, the compound semiconductor layer 3 is stacked, with the orientation of the cleavage plane of the single crystal substrate 2 being identical to the orientation of the cleavage plane of the compound semiconductor layer 3. Therefore, the side surface of the compound semiconductor layer 3 also has fine asperities.

The compound semiconductor layer 3 includes an n-type semiconductor layer 31, an active layer 32, and a p-type semiconductor layer 33. A buffer layer can be provided between the n-type semiconductor layer 31 and the individual piece 2. The compound semiconductor layer 3 is formed by sequentially growing the n-type semiconductor layer 31, the active layer 32, and the p-type semiconductor layer 33 on the single crystal substrate (wafer) 2 using a crystal growing apparatus.

Above the wafer provided with the compound semiconductor layer 3, the p-type semiconductor layer 33, the active layer 32, and a part of the n-type semiconductor layer 31 are removed by dry etching or the like to expose a region, on which the n-type electrode 4 is to be formed. When the single crystal substrate 2 has n-type conductivity, the n-type semiconductor layer 31 may be also removed to expose the single crystal substrate 2 to form the n-type electrode 4 on the single crystal substrate 2. When the single crystal substrate 2 has the n-type conductivity, an n-type electrode may be formed on a surface opposite to the surface of the single crystal substrate 2, on which the compound semiconductor layer 3 is stacked. In this case, dry etching is not necessarily required.

The n-type electrode 4 is preferably formed on and in contact with the n-type semiconductor layer 31 or a conductive substrate, and is preferably made of Al with high reflectivity so that the light emitting plane reflects light. On the other hand, the surface of the n-type electrode 4 is preferably made of Au to function as an electrode for bonding. Therefore, it is preferable that an Al layer is formed, on which a barrier metal layer made of an element of Ti, Pt, or Ni is formed; and then an Au layer is formed on the barrier metal layer.

The p-type electrode 5 is an electrode for bonding, and is made of Au. The p-type electrode 5 may have a multilayer structure. For example, a contact layer can be formed to obtain ohmic contact with the p-type semiconductor layer 33. The contact layer can be made of one of In, Zn, Pt, Pd, Ni, Co, and Mg; or an alloy or a conductive film containing at least one of the metals. When the contact layer is the conductive layer, it can be made of ITO or ZnO.

After forming the contact layer, a reflective layer for reflecting light passing from the p-type semiconductor layer 33 toward the single crystal substrate 2 may be formed. The reflective layer can be made of Ag, Al, or Rh; or an alloy containing at least one of the metals. Ag or an Ag alloy is preferable, since they have high reflectivity.

Referring to FIG. 2, the semiconductor light emitting element of the present invention has a rectangular shape when viewed from the p-type electrode 5. The semiconductor light emitting element has generally a substantially square shape. However, in recent years, with increasing use of semiconductor light emitting elements for illumination in white color in combination with fluorescent materials, rectangular semiconductor light emitting elements have been increasingly demanded. The rectangular elements are most typically used in mobile phones, car navigation systems, and backlights of laptop computers; and have been widely used as backlights of liquid crystal displays. The present invention particularly relates to such rectangular semiconductor light emitting elements. Therefore, the semiconductor light emitting element of the present invention has a pair of side surfaces on long sides, and a pair of side surfaces on short sides. The side surfaces on the long sides and the short sides are referred to as "long side surfaces" and "short side surfaces," respectively. In the present invention, the rectangular shape denotes the rectangle in which the length ratio of the short surfaces to the long surfaces is 1 to 1.5 or more, preferably 2 or more, and more preferably 3 or more.

The semiconductor light emitting element 1 formed by separating the single crystal substrate 2 will be further described specifically with reference to FIGS. 3 and 4. FIG. 3 illustrates, as described above, the single crystal substrate of the semiconductor light emitting element according to the embodiment of the present invention. FIG. 4 is a perspective view illustrating the relationship between a wafer 10 and a crystal plane of the single crystal substrate.

As shown in FIG. 3, the wafer 10 includes the compound semiconductor layer 3 stacked on the c plane of the single crystal substrate, and is provided with the n-type electrode 4 and the p-type electrode 5. After being scribed, the wafer is separated into individual pieces along scribe lines to be semiconductor light emitting elements 1. The wafer 10 has a rectangular shape including an OF plane 11, which servers as a reference when separating the wafer and forming a electrode pattern; and is made of nitride compound semiconductor, silicon carbide semiconductor, or zinc oxide compound semiconductor, which have hexagonal crystal structures. In such semiconductor having the hexagonal crystal structure, each of the (1-100) plane, the (01-10) plane, and the (10-10) plane, which are the cleavage planes, is oriented at an angle of 60°. These planes are referred to as "m planes." Strictly speaking, orientation of a front plane and a back plane of the surface is represented by different reference numerals. However, in the present invention, for example, the (1-100) plane denotes both of the (1-100) plane and the (-1100) plane.

In FIG. 3, the n-type electrode 4 and the p-type electrode 5 are formed on the wafer 10 so that the short side surfaces of a rectangular light emitting element is parallel to the OF plane 11, and so that the alignment is parallel or vertical to the OF plane 11. The figure shows that the wafer 10 is separated along an electrode pattern in a direction parallel or vertical to the OF plane 11.

Note that the shape of the wafer 10 is not limited to rectangular, but the wafer may have a substantially disk shape or other shapes, as long as it has the OF plane 11 or a mark corresponding to the plane.

In FIG. 3, the OF plane 11 is oriented at an angle of 0° with respect to the (10-10) plane being the cleavage plane. By separating the wafer 10 along the electrode pattern, the side surface 24 of the rectangular-shaped individual piece 2 is oriented at an angle of 0° with respect to the (10-10) plane being the cleavage plane.

At this time, the side surface 21 being one of the surfaces adjacent to the side surface 24 is oriented at an angle of 90° with respect to the (10-10) plane, at an angle of 30° with respect to the (01-10) plane, and at an angle of 150° with respect to the (1-100) plane. That is, the side surface 21 does not coincide with any of the cleavage planes.

In the present invention, since each individual piece has a rectangular shape, the side surface 22 opposite to the side surface 24 has the same cleavage planes as the side surface 24, and like the side surface 21, the side surface 23 opposite to the side surface 21 does not coincide with any of the cleavage planes.

Therefore, by separating the wafer 10 being a single crystal substrate into individual pieces, the long side surface 21 (and the long side surface 23) of the individual piece 2 can be different from the cleavage planes. While the short side surface 24 is the cleavage plane at this time, when the individual piece has a rectangular shape, light extraction efficiency of the entire semiconductor light emitting element can be improved with an increase in light extraction efficiency of the long side surfaces. Therefore, with an increase in the length ratio of the long sides to the short sides, the degree of the improvement in the light extraction efficiency can be increased.

FIG. 3 shows the case where each of the short side surfaces is the (10-10) plane being the cleavage plane, as an example showing that the long side surfaces are not the cleavage planes. However, not only FIG. 3 shows that the long side surface 21 is not the cleavage plane. The long side surface 21 is not the cleavage plane, when the long side surfaces are located between the (01-10) plane and the (1-100) plane. FIG. 3 shows the case where the long surface 21 is oriented at an angle of 30° with respect to each of the cleavage planes. When the long side surface 21 is located between the (01-10) plane and the (1-100) plane, and not oriented at the angle of 30° with respect to the planes, the short side surface 24 is not parallel to the cleavage plane (10-10). As a result, none of the side surfaces is the cleavage plane. That is, asperities can be formed on all of the side surfaces.

In this case, the light extraction efficiency is improved more than in the case where the short side surfaces are the cleavage planes, and a more desirable semiconductor light emitting element can be obtained. Note that, when the long side surface 21 is located between (10-10) and (01-10), or between (10-10) and (1-100), the long side surfaces are not the cleavage planes, and similar circumstances occur.

The substrate can be easily separated by forming a groove for segmenting a wafer, which includes a compound semiconductor layer on a single crystal substrate using a laser scribing apparatus; and breaking the groove. The depth of the groove preferably ranges from 5 to 50% of the thickness of a side surface. When the depth of the groove is smaller than 5%, the wafer cannot be broken at the height of the groove, thereby reducing yields of the separation. When the depth of the groove is larger than 50%, the area of the fine asperities formed on the side surface is reduced to decrease the light extraction efficiency.

That is, when the laser scribing apparatus is used to cut out a part not being the cleavage plane as a side surface, the groove formed by the laser scribing apparatus has a relatively smooth side surface. Thus, a portion with fine asperities and a portion without the fine asperities are formed in the thickness direction of the substrate. This means that, in the semiconductor light emitting element of the present invention, the fine asperities are formed on a half or more of the side surface of the substrate in the thickness direction of the substrate.

Note that the groove by the laser scribing apparatus may be formed on the surface of the wafer provided with the compound semiconductor layer 3, or on the surface opposite to the surface provided with the compound semiconductor layer 3.

As such, simply by setting the long side surfaces of the individual piece 2 to be different from the cleavage planes, when the single crystal substrate is separated in a manufacturing process; the asperities are formed on the side surface of the semiconductor light emitting element 1 to improve the light extraction efficiency. There is no need to add an extra manufacturing step. Therefore, complication in the manufacturing process and an increase in the manufacturing cost can be alleviated.

This embodiment describes the case where the wafer is separated so that the short side surfaces of the individual piece 2 are oriented at an angle of 0° with respect to the cleavage planes. This is because, when the reference side surface of the individual piece 2 is oriented at an angle of 0° with respect to the cleavage planes, the long side surfaces can be oriented at an angle of 30° or more with respect to each of the cleavage planes. However, since the cleavage planes are necessarily oriented at an angle of 60° with respect to each other, the long side surfaces of the individual piece 2 may be oriented at an angle of more than 0° and less than 60° with respect to the cleavage planes.

However, when the angle is close to 0° or 60°, the wafer may crack from the cleavage planes, which are easily cleaved. Therefore, by setting the angle to be a range from 5° to 55°, the long side surfaces of the individual piece 2 can be oriented with an extra angle of 5° or more with respect to the cleavage planes. This reduces cracking of the wafer from the cleavage planes, when separating the wafer except for the cleavage planes.

Furthermore, when the long side surfaces of the individual piece 2 are oriented at an angle ranging from 10° to 50° with respect to the cleavage planes, each of the side surfaces of the individual piece 2 can be oriented with an extra angle of 10° or more with respect to the cleavage planes. This reliably reduces the cracking from the cleavage planes, and enables formation of a larger number of asperities, thereby further increasing the light extraction efficiency.

It is further preferable that the long side surfaces are oriented at an angle ranging from 0° to 30° with respect to the cleavage planes, since the short side surfaces can be different from the cleavage planes. With an extra angle of 5° or 10° with respect to the cleavage planes, the cracking from the cleavage planes in processing can be reduced. Specifically, the long side surfaces are preferably oriented at an angle ranging from 5° to 25°, and more preferably ranging from 10° to 20° with respect to the cleavage planes.

In the present invention, when a rectangular semiconductor light emitting element is manufactured and the long side surfaces of the element are not the cleavage planes of the single crystal, the fine asperities can be formed on the long side surfaces only by separating the element from the wafer. As a result, the light extraction efficiency can be improved. In a hexagonal single crystal, there is a combination of crystal planes capable of implementing the present invention other than the combination shown in FIG. 3.

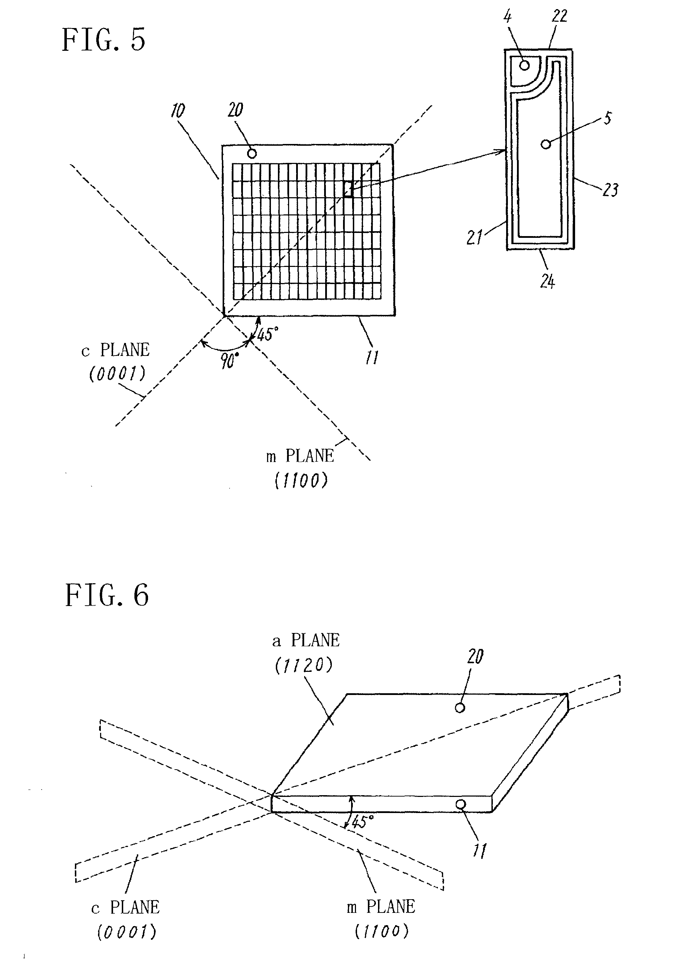

FIGS. 5 and 6 illustrate a method of separating the element from the wafer when the main surface is the a plane. In a hexagonal single crystal, the c plane (0001) and the m plane (1-100) are the cleavage planes. That is, when the main surface is the a plane, there are two cleavage planes of the c plane and the m plane at the surface separated in the substantially vertical direction to the main surface. In this case, the long side surfaces may be oriented at an angle ranging from 0° and 90° with respect to the c plane or the m plane so that the long side surface 21 is not the cleavage plane. When the extra angle with respect to the cleavage planes is 5° as described above, the long side surfaces may be oriented at an angle ranging from 5° to 85° with respect to the c plane or the m plane. In this case, the c plane and the m plane are oriented at an angle of 90° with respect to each other, the short side surfaces are also not the cleavage planes. That is, by orienting the long side surfaces at an angle ranging from 5° to 85° with respect to the c plane or the m plane using the a plane as the main surface, none of the side surfaces is the cleavage plane. Thus, the fine asperities can be formed on the side surfaces only by separating the element from the wafer to improve the light extraction efficiency. Clearly, the extra angle is preferably set at 10°.

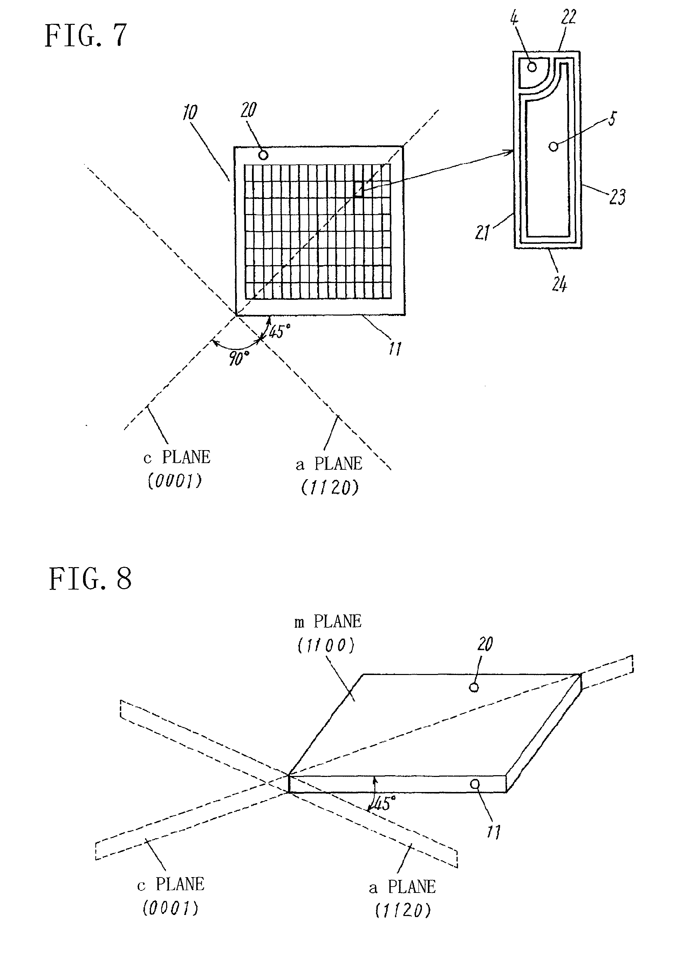

FIG. 7 and FIG. 8 illustrate a method of separating the element from the wafer, when the main surface is the m plane. The figures illustrate the case where the long side surfaces are oriented at an angle of 45° with respect to the c plane. When the m plane is the main surface, there are the c plane and the a plane at the surface. In a hexagonal single crystal, the c plane (0001) and the m plane (1-100) are the cleavage planes. That is, when the main surface is the m plane (1-100), only the c plane may be considered as the cleavage plane existing at the separated surface. In this case, the long side surfaces may be oriented at an angle ranging from 0° to 180° with respect to the c plane so that the long side surface 21 is not the cleavage plane. When the extra angle with respect to the cleavage planes is 5° as described above, the long side surfaces may be oriented at an angle ranging from 5° to 175° with respect to the c plane. Clearly, the extra angle is preferably set at 10°.

When the long side surfaces are oriented at an angle of 90° with respect to the c plane, the short side surfaces occasionally coincide with the c plane to be the cleavage planes. However, similar to the case where the main surface is the c plane, even when the short side surfaces are the cleavage planes, the light extraction efficiency of the entire element is improved, as long as fine the asperities can be formed on the long side surfaces having large areas. That is, the present invention includes the case where the short side surfaces are the cleavage planes. The long side surfaces are preferably oriented at an angle ranging from 0° to 90° with respect to the c plane, since none of the planes is the cleavage plane.

However, when the long side surfaces are oriented at an angle of 90° with respect to the c plane, the long side surfaces other than the groove for laser scribing are not vertical to the main surface, even if the groove is formed vertically to the main surface and the element is broken along the groove using the laser scribing apparatus. It is highly possible that the long side surfaces other than the groove would crack at another m plane: the m plane (01-10) or the (10-10) plane, which intersects the main surface at an angle of 60° or 120°, respectively. Therefore, the long side surfaces are more preferably oriented at an angle ranging from 0° to 60° with respect to the c plane. When the extra angle with respect to the cleavage planes is 5° as described above, the long side surfaces may be oriented at an angle ranging from 5° to 60°.

As described above, in the semiconductor light emitting element of the present invention, the c plane, the a plane, and the m plane of the hexagonal single crystal are the main surfaces; and the element is cut out from the substrate in a predetermined surface direction, thereby improving the light extraction efficiency. This semiconductor light emitting element can be used for various types of semiconductor light emitting devices.

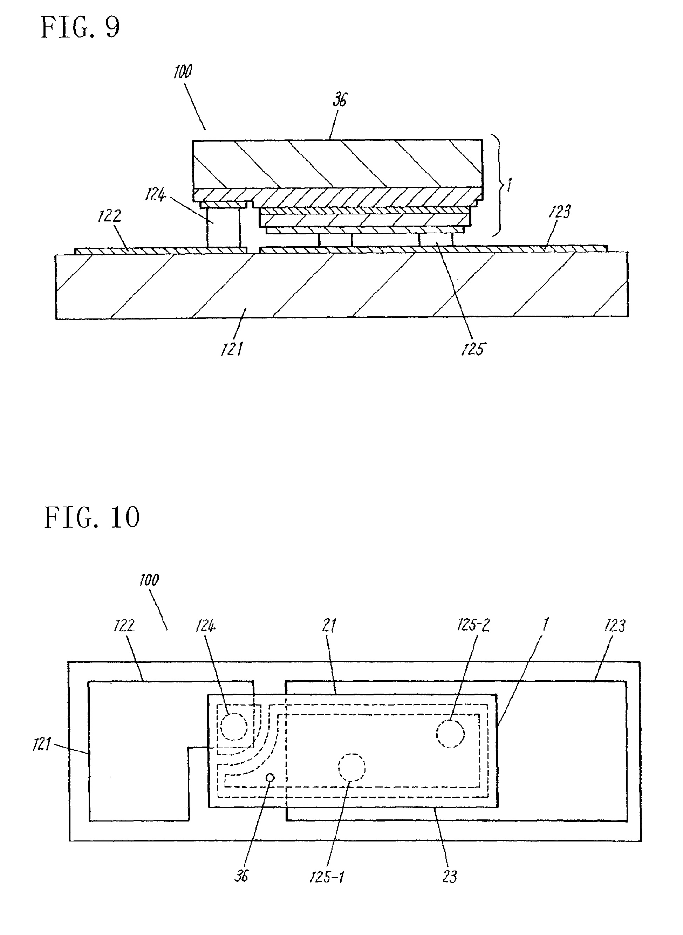

FIG. 9 and the subsequent figures illustrate specific examples of a semiconductor light emitting device 100 using the semiconductor light emitting element 1 of this embodiment. FIG. 9 illustrates an example where the substrate surface opposite to the compound semiconductor layer 3 of the semiconductor light emitting element in FIG. 1 is a light emitting plane 36. The substrate 2 is made of a hexagonal single crystal using any one of the above-described methods. The n-type electrode and the p-type electrode are formed as shown in FIG. 1.

A submount 121 is provided with extraction electrodes 122 and 123. The extraction electrodes are for applying currents to the semiconductor light emitting element 1. There are the n-side extraction electrode 122 coupled to the n-type layer side of the semiconductor light emitting element, and the p-side extraction electrode 123 coupled to the p-type layer side.

The submount 121 can be made of, e.g., silicon zener diode, silicon diode, silicon, aluminum nitride, alumina, or other ceramics.

The extraction electrodes are provided with bumps 124 and 125. As the extraction electrodes are, there are the bumps of the n-side bump 124 coupled to the n-type layer side, and the p-side bump 125 coupled to the p-type layer side. FIG. 9 shows a plurality of p-side bumps, which are denoted by reference numeral 125 as a whole. Clearly, there may be a plurality of n-side bumps. The extraction electrodes and the semiconductor light emitting element are electrically coupled together with the bumps.

The bumps have the function of fixing the semiconductor light emitting element 1 onto the submount 121, and electrically coupling the extraction electrode 122 to the extraction electrode 123.

The bumps can be made of, e.g., gold, gold-tin, solder, an indium alloy, and conductive polymer. In particular, gold or a material containing gold as a main component is preferable. The bumps can be formed, e.g., by plating, vacuum deposition, screenprinting, spraying, and wire bumping using these materials.

For example, a gold wire is formed by wire bumping, and the end of the wire is boded to the extraction electrodes on the submount using a bonder. Then, the wire is cut off, thereby forming a gold bump. Also, spraying can be used, in which liquid containing fine nanoparticles of a high conductive material such as gold dispersed in a volatile solvent is sprayed by a method similar to ink jet printing, and the solvent is volatilized to form a bump as an aggregation of the nanoparticles.

FIG. 10 is a plan view seen from the light emitting plane 36 in FIG. 9. As shown in the figure, two or more p-side bumps are provided. If there is only a single p-side bump, the semiconductor light emitting element 1 is fixed onto the submount 121 with two bumps of the n-side bump and the p-side bump to become unstable.

Also, at least one of the p-side bumps is located near the long side surface on the same side as the n-side bump, and at least one of the p-side bumps is located near the long side surface on the opposite side to the n-side bump. Specifically, referring to FIG. 10, the p-side bump 125-1 is disposed at the side of the side surface 23, which is on the opposite side to the side surface 21 provided with the n-side bump 124. The p-side bump 125-2 is disposed at the side of the side surface 21, which is on the same side as the side surface 21 provided with the n-side bump 124. Since the p-side bumps are disposed in this manner, the semiconductor light emitting element 1 is firmly fixed onto the submount 121 by three-point support formed by three bumps arranged in a triangle.

Furthermore, the p-side bump 125-2 disposed at the side of the side surface, which is on the same side as the n-side bump, is preferably disposed apart from the n-side bump 124 as far as possible. This is to increase the area of the triangle formed by the three bumps. When the triangle has a large area, the semiconductor light emitting element 1 is firmly fixed. The third and subsequent p-side bumps may be disposed in any position.

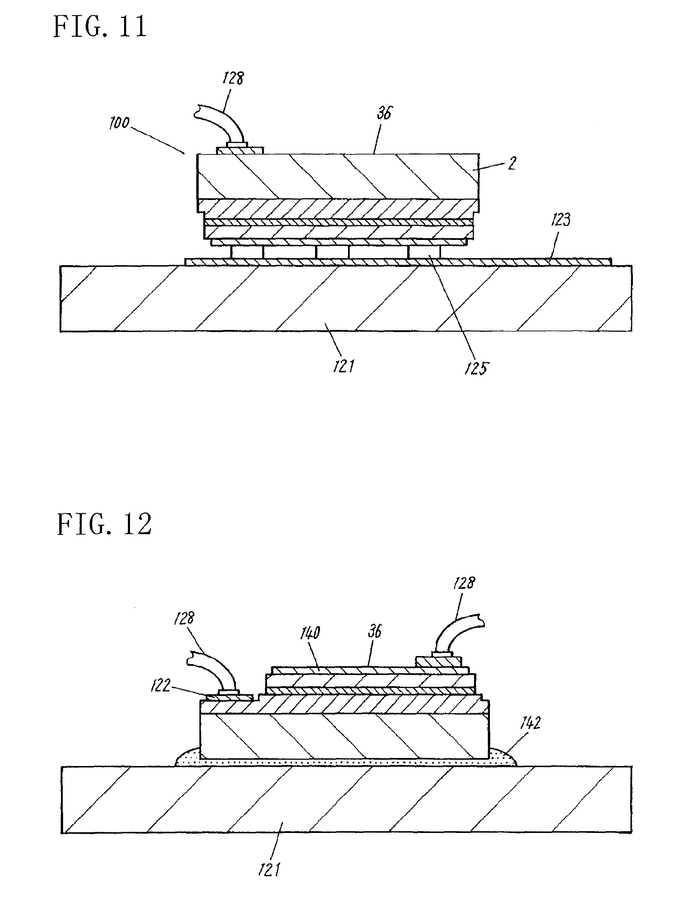

FIG. 11 illustrates another example where the light emitting plane 36 is at the side of the substrate, which is not provided with a compound semiconductor layer. This example shows a semiconductor light emitting device, where a substrate 2 is conductive. A p-type electrode is formed on the entire surface of the compound semiconductor layer. An n-type electrode is directly formed on the conductive substrate, and is electrically charged from the outside by a bonding wire 128. Only a p-side extraction electrode 123 may be formed on the submount. While in FIG. 11, the n-type layer is exposed by etching near the side surface, the n-type layer may not be exposed by etching.

FIG. 12 illustrates an example where the light emitting plane 36 is formed at the side of the compound semiconductor layer. The substrate side of the semiconductor light emitting element is bonded to the submount 121. Adhesive 142 made of solder, silver paste, or a resin is preferably used. The n-type electrode 122 is formed as shown in FIG. 1. On the other hand, a transparent electrode 140 is used as the p-type electrode, since it serves as the light emitting plane 36. The p-type electrode and the n-type electrode are coupled to not-shown electrode terminals with the bonding wire 128.

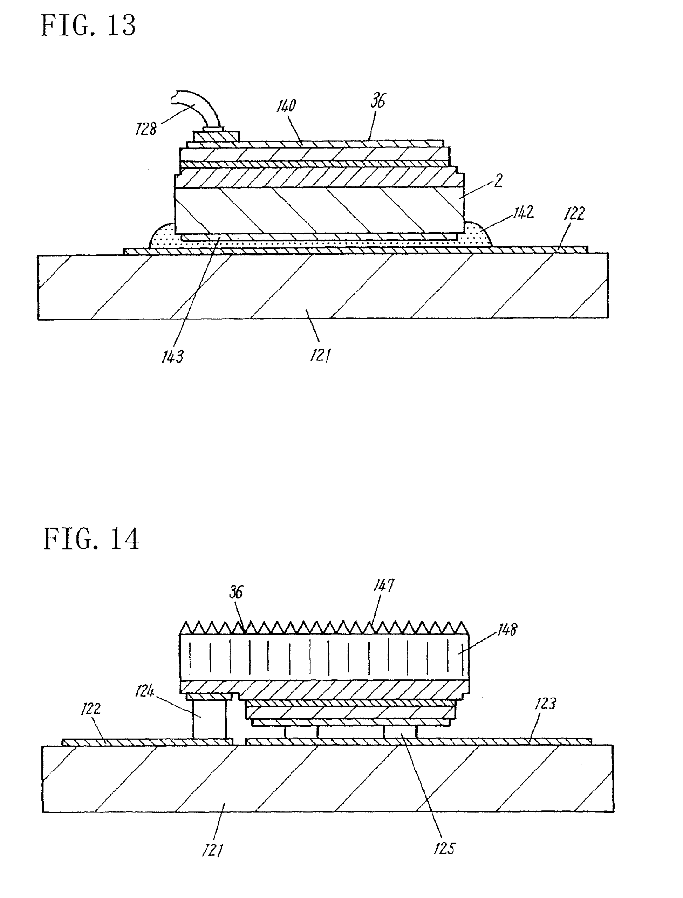

FIG. 13 illustrates another example where the light emitting plane 36 is at the side of a p-type electrode as in FIG. 12. The submount 121 is provided with the extraction electrode 122 for an n-type electrode. A conductive substrate is used as a substrate 2. The extraction electrode 122 on the submount is bonded to the conductive substrate 2 with the conductive adhesive 142 such as solder or silver paste. In order to reduce ohmic resistance, an electrode layer 143 made of, e.g., Pt, Ni, Co, or ITO may be added. While in FIG. 13, the n-type layer is exposed by etching near the side surface, the n-type layer may not be exposed by etching.

In the present invention, a compound semiconductor layer is formed using any of the c plane, the a plane, and the m plane of a hexagonal single crystal as the main surface, the cutting direction of the substrate is oriented at a predetermined angle so that the long side surfaces are not the cleavage planes, and fine asperities are formed only by the step of separating the substrate, thereby improving the light extraction efficiency. Clearly, the fine asperities may be formed on the light emitting plane itself.

FIG. 14 illustrates a semiconductor light emitting device, in which the long side surfaces are not the cleavage planes, and fine asperities 147 are formed on the light emitting plane 36 of the semiconductor light emitting element 1 having on the side surface, fine asperities 148 formed by cutting out the element. FIG. 14 illustrates the semiconductor light emitting device, in which the fine asperities 147 for reducing total reflection are formed on the light emitting plane of the semiconductor light emitting device in FIG. 9. Therefore, the submount 121, the extraction electrodes 122 and 123, and bumps 124 and 125 are as described in FIG. 9.

There are several methods of forming the fine asperities 147, and any method may be used. However, a method applying less mechanical stress is preferable. Specifically, a method with etching may be used. Forming the asperities on a surface by etching is a simple step and improves the light extraction efficiency. However, as a feature, the method has difficulty in accurately controlling the asperities, and exactly same asperities cannot be formed on the light emitting plane. Wet etching or dry etching can be used as etching. For example, ion milling or a chlorine gas method can be used as dry etching. An etchant containing alkali as a main component may be used in wet etching.

The asperities can be formed on the outer surface of the light emitting plane by ink jet printing. The method can be easily implemented, since it does not include the step of etching the light emitting plane. Furthermore, the light extraction efficiency can be further improved by adjusting refractivity of a material for asperities mixed into ink.

Moreover, if mechanical stress may be applied to some extent, a mechanical processing method using, e.g., nanoimprint technology can be used. In the nanoimprint technology, a sealing resin is applied to the light emitting plane and cured, and then asperities can be formed on the light emitting plane 36 by blasting.

Also, after the sealing resin is cured once, the surface is polished to be smooth, and a liquid resin is thinly applied to the polished surface to form a film, which is subjected to nanoimprinting to form asperities. Note that a sealing layer containing a fluorescent material may be provided between the light emitting plane and the surface subjected to anti-reflection treatment of the substrate.

### INDUSTRIAL APPLICABILITY

The present invention enables formation of asperities on the side surface of a semiconductor light emitting element without requiring any additional manufacturing step, thereby improving light extraction efficiency, and is thus preferable as a semiconductor light emitting element formed by staking a semiconductor layer on a translucent substrate.

## Claims

1. A semiconductor light emitting element having a rectangular shape, comprising a nitride semiconductor layer stacked on a main surface provided on a single crystal substrate, and formed by separating the single crystal substrate, wherein
a long side surface, which is a side surface in a long side direction, is separated in a direction different from a cleavage plane of the single crystal substrate.

2. The semiconductor light emitting element of claim 1, wherein
the ratio of a short side to a long side of the semiconductor light emitting element is 1:2 or more.

3. The semiconductor light emitting element of claim 1 or 2, wherein
the single crystal substrate is made of hexagonal semiconductor,
the main surface is a (0001) c plane, and
the long side surface is oriented at an angle ranging from 5° to 55° with respect to an m plane of the single crystal substrate.

4. The semiconductor light emitting element of claim 3, wherein
the long side surface is oriented at an angle ranging from 5° to 25° with respect to the m plane of the single crystal substrate.

5. The semiconductor light emitting element of claim 1 or 2, wherein
the single crystal substrate is made of hexagonal semiconductor,
the main surface is a (1-100) m plane, and
the long side surface is oriented at an angle ranging from 5° to 175° with respect to a c plane of the single crystal substrate.

6. The semiconductor light emitting element of claim 5, wherein
the long side surface is oriented at an angle ranging from 5° to 85° with respect to the c plane of the single crystal substrate.

7. The semiconductor light emitting element of claim 5, wherein
the long side surface is oriented at an angle ranging from 5° to 60° with respect to the c plane of the single crystal substrate.

8. The semiconductor light emitting element of claim 1 or 2, wherein
the single crystal substrate is made of hexagonal semiconductor,
the main surface is a (11-20) a plane, and
the long side surface is oriented at an angle ranging from 5° to 85° with respect to a c plane or an m plane of the single crystal substrate.

9. The semiconductor light emitting element of any one of claims 3-8,
wherein
the single crystal substrate is the single crystal substrate made of one material selected from nitride compound semiconductor, silicon carbide semiconductor, and zinc oxide compound semiconductor.

10. The semiconductor light emitting element of any one of claims 1-9,
wherein
the long side surface has fine asperities in a half or more region of the long side surface in a thickness direction.

11. A semiconductor light emitting device using the light emitting element of any one of claims 1-10.

12. The semiconductor light emitting device of claim 11, wherein
a compound semiconductor layer including an n-type electrode and a p-type electrode is formed on one side of a substrate and is fixed to a submount with bumps,
the number of p-side bumps is two or more, and
at least one of the p-side bumps is disposed at a side of the long side surface on a same side as an n-side bump, and at least one of the p-side bump is disposed at a side of the long side surface on an opposites side to the n-side bump.

13. A method of manufacturing a rectangular semiconductor light emitting device, comprising:
forming an n-type semiconductor layer, an active layer, and a p-type semiconductor layer on a hexagonal semiconductor single crystal substrate;
removing the active layer and the p-type semiconductor layer on a partial region of the hexagonal semiconductor single crystal substrate to expose the n-type semiconductor layer or the hexagonal semiconductor single crystal substrate;
forming an n-type electrode and a p-type electrode on the exposed n-type semiconductor layer or the hexagonal semiconductor single crystal substrate and the p-type semiconductor layer, respectively; and
forming a cut groove by laser scribing so that a plane of the hexagonal semiconductor single crystal substrate, which is not a cleavage plane, is a long side surface.

14. A method of manufacturing a rectangular semiconductor light emitting device, comprising:
forming an n-type semiconductor layer, an active layer, and a p-type semiconductor layer on a hexagonal semiconductor single crystal substrate having n-type conductivity;
forming an n-type electrode and a p-type electrode on a back surface of the hexagonal semiconductor single crystal substrate and in the p-type semiconductor layer, respectively; and
forming a cut groove by laser scribing so that a plane of the hexagonal semiconductor single crystal substrate, which is not a cleavage plane, is a long side surface.

15. The method of claim 13 or 14, wherein
in the forming the cut groove, the cut groove has a depth ranging from 5% to 50% of a thickness of the hexagonal semiconductor single crystal substrate.
